# EUROPEAN PATENT APPLICATION

(11) **EP 1 317 170 A2**
(43) Date of publication of application: **04.06.2003**
(21) Application number: 02257922.1
(22) Date of filing: 15.11.2002
(51) Int. Cl.: H05K 9/00, H05K 1/02, H03H 1/00

(54) **Shielding structure for resonant circuit**

(30) Priority: 30.11.2001 JP 2001366406
(71) Applicant: ALPS ELECTRIC CO., LTD., Ota-ku Tokyo 145 (JP)
(72) Inventor: Wakamori, Masahiro, c/o Alps Electric Co., Ltd., Tokyo (JP)
(74) Representative: Kensett, John Hinton

(57) **Abstract**

A shielding structure for a resonant circuit according to the present invention includes a grounding conductor (4) which surrounds the periphery of the resonant circuit and which has conductive tab portions (4b) which oppose each other across a cut portion (4c), the conductive tab portions being connected to each other by a connecting conductor which is placed on a pair of first conductive pattern elements (2b) so as to intersect the pair of first conductive pattern elements. The resonant circuit is shielded by a closed shielding unit (13) constructed of the grounding conductor and the connecting conductor, so that the radiation from the grounding conductor is reduced.

## Description

### BACKGROUND OF THE INVENTION

### 1. Field of the Invention

The present invention relates to a shielding structure for a resonant circuit which is suitable for use in, for example, a television tuner.

### 2. Description of the Related Art

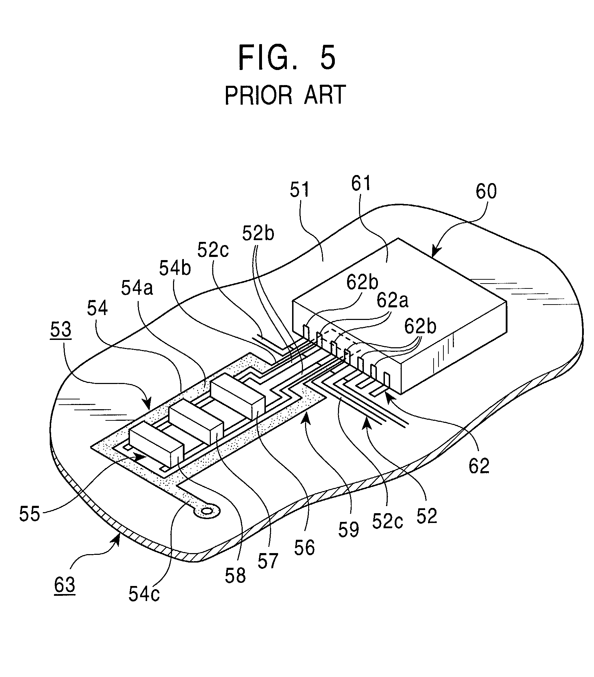

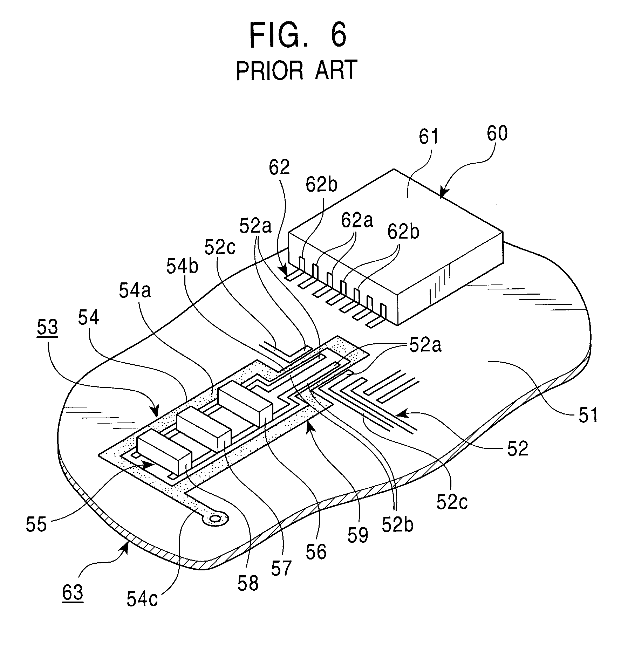

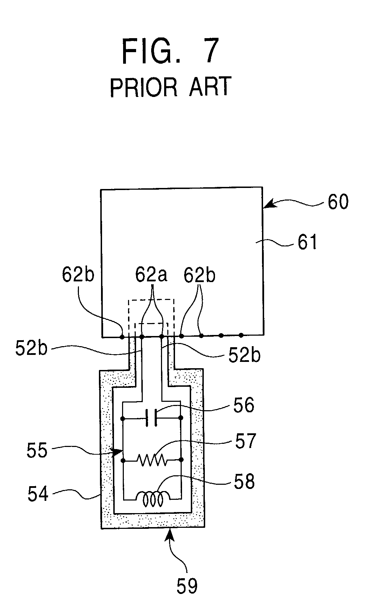

Fig. 5 is a perspective view showing the actual wiring of a known shielding structure for a resonant circuit, Fig. 6 is an exploded perspective view showing the actual wiring of the known shielding structure for the resonant circuit, and Fig. 7 is a wiring diagram of the known shielding structure for the resonant circuit.

The known shielding structure for the resonant circuit will be described below with reference to Figs. 5 to 7. As shown in the figures, a first conductive pattern 52 for wiring and a second conductive pattern 53 for grounding are formed on a printed board 51 in such a manner that they are flush with each other.

The first conductive pattern 52 for wiring includes a plurality of lands 52a which are formed parallel to each other at positions close to each other, a pair of conductive pattern elements 52b which extend parallel to each other from a pair of the lands 52a to form a resonant circuit (which will be described below), and conductive pattern elements 52c which extend from the lands 52a excluding the pair from which the pair of conductive pattern elements 52b extends.

The second conductive pattern 53 for grounding includes a grounding conductor 54 which is formed so as to surround the entire periphery of the pair of conductive pattern elements 52b and which includes wide portions 54a, narrow portions 54b, and a leading portion 54c which is continuous to the wide portions 54a.

Each of the narrow portions 54b is disposed between two adjacent lands 52a which are formed parallel to each other at positions close to each other so that the grounding conductor 54 is not electrically connected to the lands 52a.

As shown in particular in Fig. 7, a resonant circuit 55 (parallel resonant circuit) is constructed by connecting a capacitor 56, a resistor 57, and a coil 58 in parallel with each other between the pair of conductive pattern elements 52b.

In addition, as shown in Figs. 5 and 6, each of the capacitor 56, the resistor 57, and the coil 58 is a chip component, and the chip capacitor 56, the chip resistor 57, and the chip coil 58 are soldered between the pair of conductive pattern elements 52b.

The resonant circuit 55 is surrounded by the grounding conductor 54 and is thereby shielded by a closed shielding unit 59 which is constructed of the grounding conductor 54.

An IC component 60 which contains an oscillating transistor includes a main body 61 and a plurality of terminals 62 which projects outward from a side surface of the main body 61 such that they are parallel to each other.

In addition, among the terminals 62, a pair of terminals 62a is connected to the oscillating transistor contained in the main body 61, and is also connected to the lands 52a for the pair of conductive pattern elements 52b which forms the resonant circuit 55 by soldering. Other terminals 62b are connected to the lands 52a for the conductive pattern elements 52c by soldering.

When the IC component 60 is attached, a part of the grounding conductor 54 is disposed under the main body 61 of the IC component 60 and the pair of terminals 62a is shielded by the grounding conductor 54.

A circuit board 63 is constructed in this manner, and when the circuit board 63 is installed in an electronic device, the leading portion 54c of the grounding conductor 54 is connected to the chassis (not shown) of the electronic device by soldering.

The known shielding structure for the resonant circuit has the above-described construction, and when the oscillating transistor of the IC component 60 operates, a high-frequency current flows in the pair of conductive pattern elements 52b which is connected to the pair of terminals 62a and in the resonant circuit 55.

At this time, the high-frequency current is transmitted to the narrow portions 54b of the grounding conductor 54 which are in the vicinity of the conductive pattern elements 52b, and the signals radiate from the grounding conductor 54.

In the known shielding structure for the resonant circuit, the entire periphery of the resonant circuit 55 is surrounded by the grounding conductor 54. Therefore, there is a problem in that the signals from the IC component 60 are transmitted to the narrow portions 54b via the conductive pattern elements 52b and a large amount of signals radiate from the grounding conductor 54.

In addition, the grounding conductor 54 is required to have the narrow portions 54b in order to dispose a part of the grounding conductor 54 between the lands 52a. Accordingly, there is also a problem in that the width of the grounding conductor 54 is partially reduced and performance in shielding the resonant circuit 55 is degraded.

### SUMMARY OF THE INVENTION

Accordingly, an object of the present invention is to provide a high-performance shielding structure for a resonant circuit which causes only small electric-wave radiation.

According to the present invention, a shielding structure for a resonant circuit includes a circuit board which has a first conductive pattern for wiring, a second conductive pattern for grounding, an IC component mounted on the circuit board, and the resonant circuit. The first conductive pattern includes a pair of first conductive pattern elements which is connected to a pair of terminals provided on the IC component and which serves as a part of the resonant circuit, and the second conductive pattern includes a grounding conductor which surrounds the periphery of the resonant circuit, the grounding conductor having a cut portion through which the pair of first conductive pattern elements extends and conductive tab portions which oppose each other across the cut portion. In addition, the conductive tab portions are connected to each other by a connecting conductor which is placed on the pair of first conductive pattern elements so as to intersect the pair of first conductive pattern elements. Thus, the resonant circuit is shielded by a closed shielding unit constructed of the grounding conductor and the connecting conductor. Therefore, although a current is induced in the connecting conductor due to the current which flows in the pair of first conductive pattern elements disposed in the vicinity of the connecting conductor, the directions of the currents are opposite, so that they cancel each other. Accordingly, the electrical potential of the grounding conductor is zero, and the electric-wave radiation from the grounding conductor is extremely low.

In addition, since the conductive tab portions of the grounding conductor are connected to each other by the connecting conductor which is placed on the pair of first conductive pattern elements so as to intersect the pair of first conductive pattern elements, it is not necessary to dispose a part of the grounding conductor between the lands as in the known technique. Accordingly, the width of the grounding conductor and that of the connecting conductor can be increased, and the shielding performance can be improved.

Preferably, the connecting conductor is a chip component. In such a case, it can be easily attached and the insulation from the pair of first conductive pattern elements can be ensured.

In addition, preferably, the chip component includes an insulator, an electrode disposed around the periphery of the insulator, and an insulating film which covers the periphery of the electrode such that the electrode is exposed at both ends of the insulator, and the electrode, which is exposed at both ends of the insulator, is connected to the conductive tab portions of the grounding conductor while the insulating film is placed on the first conductive pattern elements. In such a case, the chip component can be easily attached and the insulation from the pair of first conductive pattern elements can be ensured.

In addition, preferably, the grounding conductor is 'C'-shaped, and the conductive tab portions extend perpendicularly to the pair of first conductive pattern elements. In such a case, the size of the connecting conductor can be reduced and the major part of the resonant circuit can be shielded by the grounding conductor, and the shielding performance can be improved.

Embodiments of the present invention will now be described, by way of example only, with reference to the accompanying diagrammatic drawings, in which:
Fig. 1 is a perspective view showing the actual wiring of a shielding structure for a resonant circuit according to an embodiment of the present invention;
Fig. 2 is an exploded perspective view showing the actual wiring of the shielding structure for the resonant circuit;
Fig. 3 is a sectional view of the main part of the shielding structure for the resonant circuit;
Fig. 4 is a wiring diagram of the shielding structure for the resonant circuit;
Fig. 5 is a perspective view showing the actual wiring of a known shielding structure for a resonant circuit;
Fig. 6 is an exploded perspective view showing the actual wiring of the known shielding structure for the resonant circuit; and
Fig. 7 is a wiring diagram of the known shielding structure for the resonant circuit.

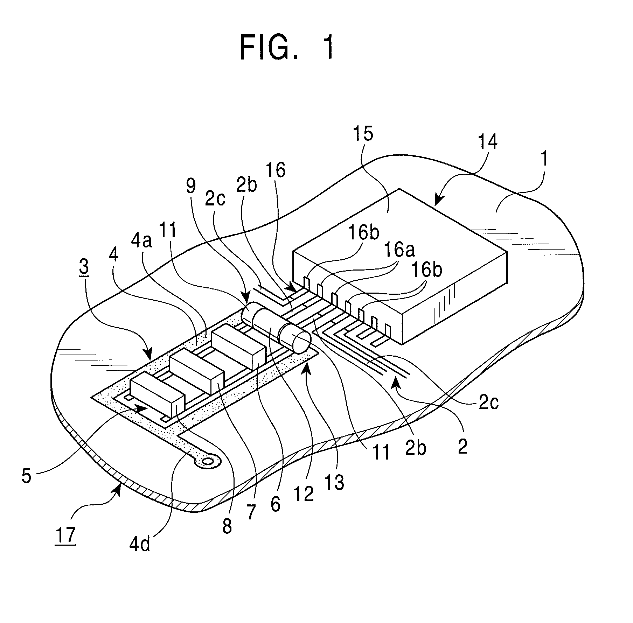

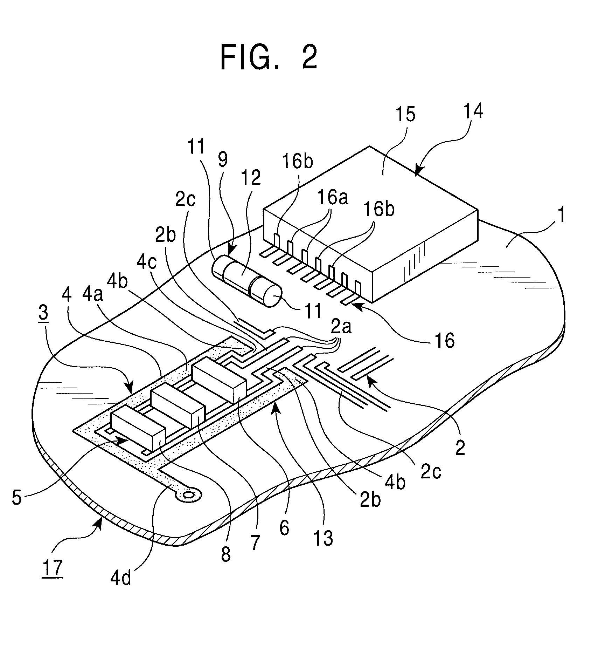

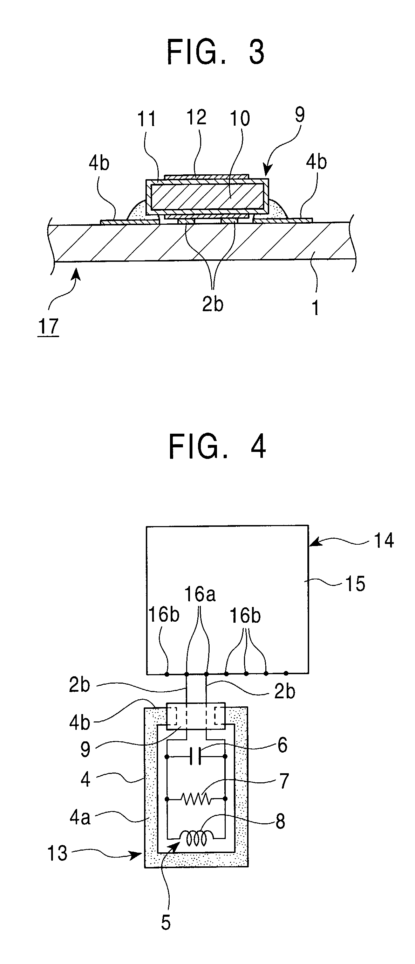

Fig. 1 is a perspective view showing the actual wiring of a shielding structure for a resonant circuit according to the present invention, Fig. 2 is an exploded perspective view showing the actual wiring of the shielding structure for the resonant circuit, Fig. 3 is a sectional view of the main part of the shielding structure for the resonant circuit, and Fig. 4 is a wiring diagram of the shielding structure for the resonant circuit.

The shielding structure for the resonant circuit according to the present invention will be described below with reference to Figs. 1 to 4. As shown in the figures, a first conductive pattern 2 for wiring and a second conductive pattern 3 for grounding are formed on a printed board 1 in such a manner that they are flush with each other.

The first conductive pattern 2 for wiring includes a plurality of lands 2a which are formed parallel to each other at positions close to each other, a pair of conductive pattern elements 2b which extend parallel to each other from a pair of the lands 2a to form a resonant circuit (which will be described below), and conductive pattern elements 2c which extend from lands 2a excluding the pair from which the pair of conductive pattern elements 2b extends.

The second conductive pattern 3 for grounding includes a 'C'-shaped grounding conductor 4. The width of the grounding conductor 4 is relatively large over the entire region. In addition, the grounding conductor 4 includes a bracket-shaped main portion 4a, a pair of conductive tab portions 4b which extends from the main portion 4a such that they oppose each other at one side of the main portion 4a, a cut portion 4c which is provided between the conductive tab portions 4b, and a leading portion 4d which extends from the main portion 4a.

The pair of conductive pattern elements 2b extends through the cut portion 4c and the periphery of the pair of conductive pattern elements 2b is surrounded by the grounding conductor 4 at one side of the pair of conductive pattern elements 2b (the side opposite to the lands 2a).

The pair of conductive tab portions 4b is disposed at a position close to the lands 2a for the pair of conductive pattern elements 2b, and extends perpendicularly to the conductive pattern elements 2b.

The conductive tab portions 4b may also be formed as a part of the main portion 4a.

As shown in particular in Fig. 4, a resonant circuit 5 (parallel resonant circuit) is constructed by connecting a capacitor 6, a resistor 7, and a coil 8 in parallel with each other between the pair of conductive pattern elements 2b.

In addition, as shown in Figs. 1 and 2, each of the capacitor 6, the resistor 7, and the coil 8 is a chip component, and the chip capacitor 6, the chip resistor 7, and the chip coil 8 are soldered between the pair of conductive pattern elements 2b.

In addition, the resonant circuit 5 is surrounded by the part of the grounding conductor 4 excluding the leading portion 4d.

In the resonant circuit 5, the chip resistor 7 may be omitted and the resonant circuit 5 may also be constructed of the chip capacitor 6 and the chip coil 8.

A connecting conductor 9 is a chip component which includes an insulator 10 having the shape of a circular column or a rectangular column, an electrode 11 which is formed around the entire periphery of the insulator 10 and which is composed of silver, etc., and an insulating film 12 which covers the periphery of the electrode 11 such that the electrode 11 is exposed at both ends of the insulator 10.

The diameter or the width of the insulator 10 is the same or larger than the width of the grounding conductor 4. Accordingly, the width of the electrode 11 formed at the periphery of the insulator 10 is also the same or larger than the width of the grounding conductor 4.

The connecting conductor 9 is installed such that the insulating film 12 is placed on the pair of conductive pattern elements 2b, so that there is no electrical connection to the pair of conductive pattern elements 2b and the electrode 11, which is exposed at both ends of the insulator 10, is connected to the conductive tab portions 4b by soldering.

Accordingly, the resonant circuit 5 is shielded by a closed shielding unit 13 which is constructed of the grounding conductor 4 and the connecting conductor 9.

When the connecting conductor 9 is attached, the connecting conductor 9 is placed on the pair of conductive pattern elements 2b such that the connecting conductor 9 intersects the pair of conductive pattern elements 2b.

The connecting conductor 9 may also be a chip component having a construction different from that described above. In addition, the connecting conductor 9 may also be constructed of, for example, a line-shaped, or a plate-shaped metal member instead of the chip component.

An IC component 14 which contains an oscillating transistor includes a main body 15 and a plurality of terminals 16 which projects outward from a side surface of the main body 15 such that they are parallel to each other.

In addition, among the terminals 16, a pair of terminals 16a is connected to the oscillating transistor contained in the main body 15, and is also connected to the lands 2a for the pair of conductive pattern elements 2b which forms the resonant circuit 5 by soldering. Other terminals 16b are connected to the lands 2a for the conductive pattern elements 2c by soldering.

A circuit board 17 is constructed in this manner, and when the circuit board 17 is installed in an electronic device, the leading portion 4c of the grounding conductor 4 is connected to the chassis (not shown) of the electronic device by soldering.

The shielding structure for the resonant circuit according to the present invention has the above-described construction, and when the oscillating transistor of the IC component 14 operates, a high-frequency current flows in the pair of conductive pattern elements 2b which is connected to the pair of terminals 16a and in the resonant circuit 5.

Although a current is induced in the connecting conductor 9 due to the current which flows in the pair of conductive pattern elements 2b disposed in the vicinity of the connecting conductor 9, the directions of the currents are opposite, so that they cancel each other.

In addition, since the grounding conductor 4 and the connecting conductor 9 are disposed at positions close to each other, the electrical potential of the grounding conductor 4 is zero, and the electric-wave radiation from the grounding conductor 4 is extremely low.

In addition, since the width of the grounding conductor 4 and that of the connecting conductor 9 are increased, the shielding performance of the shielding unit 13 is improved.

## Claims

1. A shielding structure for a resonant circuit, comprising a circuit board which has a first conductive pattern for wiring, a second conductive pattern for grounding, an IC component mounted on the circuit board, and the resonant circuit,
wherein the first conductive pattern includes a pair of first conductive pattern elements which is connected to a pair of terminals provided on the IC component and which serves as a part of the resonant circuit, and the second conductive pattern includes a grounding conductor which surrounds the periphery of the resonant circuit, the ground conductor having a cut portion through which the pair of first conductive pattern elements extends and conductive tab portions which oppose each other across the cut portion, the conductive tab portions being connected to each other by a connecting conductor which is placed on the pair of first conductive pattern elements so as to intersect the pair of first conductive pattern elements,
whereby the resonant circuit is shielded by a closed shielding unit constructed of the grounding conductor and the connecting conductor.

2. A shielding structure for a resonant circuit according Claim 1, wherein the connecting conductor is a chip component.

3. A shielding structure for a resonant circuit according Claim 2, wherein the chip component includes an insulator, an electrode disposed around the periphery of the insulator, and an insulating film which covers the periphery of the electrode such that the electrode is exposed at both ends of the insulator, and
wherein the electrode, which is exposed at both ends of the insulator, is connected to the conductive tab portions of the grounding conductor while the insulating film is placed on the first conductive pattern elements.

4. A shielding structure for a resonant circuit according to Claim 1, wherein the grounding conductor is 'C'-shaped, and the conductive tab portions extend perpendicularly to the pair of first conductive pattern elements.
